# EUROPEAN PATENT SPECIFICATION

(11) **EP 2 880 665 B1**
(45) Date of publication and mention of the grant of the patent: **25.12.2019**
(21) Application number: 13748182.6
(22) Date of filing: 30.07.2013
(51) Int. Cl.: H01F 10/30, H01F 10/32, H01F 41/30

(54) **CO/NI MULTILAYERS WITH IMPROVED OUT-OF PLANE ANISOTROPY FOR MAGNETIC DEVICE APPLICATIONS**
CO/NI-MEHRFACHSCHICHTE MIT VERBESSERTER SENKRECHTER ANISOTROPIE ZUR VERWENDUNGEN ALS MAGNETISCHES BAUTEIL
MULTICOUCHES CO/NI AVEC ANISOTROPIE HORS DU PLAN AMÉLIORÉE POUR DES APPLICATIONS DE COMPOSANT MAGNETIQUE

(30) Priority: 30.07.2012 US 201213561201
(43) Date of publication of application: 10.06.2015
(73) Proprietor: Headway Technologies, Inc., Milpitas, CA 95035 (US)
(72) Inventor: JAN, Guenole, San Jose, CA 95125 (US); TONG, Ru-Ying, Los Gatos, CA 95032 (US); WANG, Yu-Jen, San Jose, CA 95130 (US)
(74) Representative: Schuffenecker, Thierry
(86) International application number: PCT/US2013/052607
(87) International publication number: WO 2014/022329

(56) References cited:
- US-A1- 2008 151 615
- US-A1- 2011 096 443
- US-A1- 2011 273 802
- US-A1- 2011 279 921

## Description

### FIELD OF THE INVENTION

The invention relates to a magnetic device that employs a thin film made of a Ni/Co laminate or the like with a magnetization direction which is perpendicular to the plane of the film (perpendicular magnetic anisotropy or PMA) wherein PMA is enhanced by an improved seed layer that induces a strong (111) crystal structure in the Ni/Co multilayer stack.

### BACKGROUND OF THE INVENTION

Magnetoresistive Random Access Memory (MRAM), based on the integration of silicon CMOS with magnetic tunnel junction (MTJ) technology, is a major emerging technology that is highly competitive with existing semiconductor memories such as SRAM, DRAM, and Flash. Similarly, spin-transfer (spin torque or STT) magnetization switching described by C. Slonczewski in "Current driven excitation of magnetic multilayers", J. Magn. Magn. Mater. V 159, L1-L7 (1996), has stimulated considerable interest due to its potential application for spintronic devices such as spin-torque MRAM on a gigabit scale.

Both MRAM and STT-MRAM may have a MTJ element based on a tunneling magneto-resistance (TMR) effect wherein a stack of layers has a configuration in which two ferromagnetic layers are separated by a thin non-magnetic dielectric layer. The MTJ element is typically formed between a bottom electrode such as a first conductive line and a top electrode which is a second conductive line at locations where the top electrode crosses over the bottom electrode. A MTJ stack of layers may have a bottom spin valve configuration in which a seed layer, an anti-ferromagnetic (AFM) pinning layer, a ferromagnetic "pinned" layer, a thin tunnel barrier layer, a ferromagnetic "free" layer, and a capping layer are sequentially formed on a bottom electrode. The pinned or reference layer has a magnetic moment that is fixed in the "y" direction, for example, by exchange coupling with the adjacent anti-ferromagnetic (AFM) layer that is also magnetized in the "y" direction. The free layer has a magnetic moment that is either parallel or anti-parallel to the magnetic moment in the pinned layer. The tunnel barrier layer is thin enough that a current through it can be established by quantum mechanical tunneling of conduction electrons. The magnetic moment of the free layer may change in response to external magnetic fields and it is the relative orientation of the magnetic moments between the free and pinned layers that determines the tunneling current and therefore the resistance of the tunneling junction. When a sense current is passed from the top electrode to the bottom electrode in a direction perpendicular to the MTJ layers, a lower resistance is detected when the magnetization directions of the free and pinned layers are in a parallel state ("0" memory state) and a higher resistance is noted when they are in an anti-parallel state or "1" memory state.

As the size of MRAM cells decreases, the use of external magnetic fields generated by current carrying lines to switch the magnetic moment direction becomes problematic. One of the keys to manufacturability of ultra-high density MRAMs is to provide a robust magnetic switching margin by eliminating the half-select disturb issue. For this reason, the spin torque MRAM was developed. Compared with conventional MRAM, spin- torque MRAM has an advantage in avoiding the half select problem and writing disturbance between adjacent cells. The spin-transfer effect arises from the spin dependent electron transport properties of ferromagnetic-spacer-ferromagnetic multilayers. When a spin-polarized current transverses a magnetic multilayer in a CPP configuration, the spin angular moment of electrons incident on a ferromagnetic layer interacts with magnetic moments of the ferromagnetic layer near the interface between the ferromagnetic and non-magnetic spacer. Through this interaction, the electrons transfer a portion of their angular momentum to the ferromagnetic layer. As a result, spin-polarized current can switch the magnetization direction of the ferromagnetic layer if the current density is sufficiently high, and if the dimensions of the multilayer are small. The difference between a spin-torque MRAM and a conventional MRAM is only in the write operation mechanism. The read mechanism is the same.

For MRAM and spin-torque MRAM applications, it is often important to take advantage of PMA films with a large and tunable coercivity field (Hc) and anisotropy field (Hk). For example, PMA films may be used as a pinned layer, free layer, or dipole (offset compensation) layer in a MTJ element or in PMA media used in magnetic sensors, magnetic data storage, and in other spintronic devices. Furthermore, a critical requirement is that Hc, Hk, and other properties such as the magnetoresistive (MR) ratio do not deteriorate during processing at elevated temperatures up to the 300°C to 400°C range. In some applications, it is also necessary to limit the overall thickness of the PMA layer and underlayers, and use only materials that are compatible with device design and processing requirements.

Materials with PMA are of particular importance for magnetic and magnetic-optic recording applications. Spintronic devices with perpendicular magnetic anisotropy have an advantage over MRAM devices based on in-plane anisotropy in that they can satisfy the thermal stability requirement and have a low switching current density but also have no limit of cell aspect ratio. As a result, spin valve structures based on PMA are capable of scaling for higher packing density which is one of the key challenges for future MRAM applications and other spintronic devices.

When the size of a memory cell is reduced, much larger magnetic anisotropy is required because the thermal stability factor is proportional to the volume of the memory cell. Generally, PMA materials have magnetic anisotropy larger than that of conventional in-plane soft magnetic materials such as NiFe or CoFeB. Thus, magnetic devices with PMA are advantageous for achieving a low switching current and high thermal stability.

Several PMA material systems have been proposed and utilized in the prior art such as multilayers of Pt/Fe, Pd/Co, and Ni/Co, and ordered (e.g., L10 structures) as well as unordered alloys but there is still a need for improvement in Hc, Hk, temperature stability, and material compatibility. There is a report by M. Nakayama et al. in "Spin transfer switching in TbCoFe/CoFeB/MgO/CoFeB/TbCoFe magnetic tunnel junctions with perpendicular magnetic anisotropy", J. Appl. Phys. 103, 07A710 (2008) related to spin transfer switching in a MTJ employing a TbCoFe PMA structure. However, in a MTJ with a TbCoFe or FePt PMA layer, strenuous annealing conditions are usually required to achieve an acceptably high PMA value. Unfortunately, high temperatures are not so practical for device integration.

Although (Co/Pt)_{X} laminates are capable of generating high PMA, Co/Pt and similar multilayers including Co/Pd and Co/lr and alloys thereof such as CoCrPt are not always desirable as a PMA layer in a MTJ element because Pt, Pd, Ir, and Cr are severe spin depolarizing materials and will seriously quench the amplitude of spintronic devices.

Among the PMA material systems studied, a Ni/Co multilayer is one of the more promising candidates because of its large potential Hc and Hk, good stability at high anneal temperatures, and potential compatibility with other materials used in magnetic devices. However, Ni/Co multilayers typically require a thick seed layer to induce high PMA. A 500 Angstrom Ti or 500 Angstrom Cu seed layer with heating to 150°C is used by P. Bloemen et al. in "Magnetic anisotropies in Co/Ni (111) multilayers", J. Appl. Phys. 72, 4840 (1992). W. Chen et al. in "Spin-torque driven ferromagnetic resonance of Co/Ni synthetic layers in spin valves", Appl. Phys. Lett. 92, 012507 (2008) describe a 1000 Angstrom Cu/200 Angstrom Pt/100 Angstrom Cu composite seed layer. The aforementioned seed layers are not practical with Ni/Co multilayer PMA configurations in spintronic devices. Typically, there is a space restriction in a direction perpendicular to the planes of the spin valve layers in advanced devices in order to optimize performance. Seed layers thicker than about 100 Angstroms will require thinning a different layer in the spin valve structure to maintain a certain minimum thickness for the MTJ element which can easily lead to performance degradation.

A [(Co/Ni)₂₀] laminated structure with a thin Ta/Ru/Cu seed layer is disclosed as a hard bias layer in U.S. Patent Application Publication 2010/0330395 and as a reference layer in U.S. Patent Application Publication 2009/0257151. However, even higher Hc is desirable to be competitive with Hc values obtained with Pt/Co and Pd/Co laminates.

In U.S. Patent 7,843,669, a fcc (111) crystal orientation is described as desirable for a pinned layer or free layer but a Ni/Co laminate with (111) orientation is not disclosed.

U.S. Patent 7,190,613 describes a fixed layer having a high coercive force and made of ordered alloys such as FePt, CoPt, and FePd, or disordered alloys including Co/Cr, Co/Pt, Co/Cr/Pt and the like. For ordered alloys with a fct(001) orientation, an underlayer such as MgO, Pt, Pd, Au, Ag, Al or Cr with a similar crystal structure is preferred.

U.S. Publication 2011/0096443 describes a MTJ for a spintronic device is disclosed and includes a thin composite seed layer made of at least Ta and a metal layer having fcc(111) or hcp(001) texture as in Ta/Ti/Cu to enhance perpendicular magnetic anisotropy (PMA) in an overlying laminated layer with a (CoFe/Ni)x, (Co/NiFe)x, (Co/NiCo)x, (CoFe/NiFe)x, or (CoFe/NiCo)x composition where x is from 5 to 30. In one embodiment, a CPP-TMR spin valve has one or both of a laminated free layer and laminated reference layer with the aforementioned compositions. The MTJ includes an interfacial layer made of CoFeB, CoFeB/CoFe, or CoFe/CoFeB between each laminated structure and the tunnel barrier. The laminated layers are deposited by a low power and high Ar pressure process to avoid damaging interfaces between adjoining layers. Annealing occurs at 220° C. to 400° C. A laminated layer with high PMA may also be included in one or more layers of a spin transfer oscillator.

U.S. Publication 2011/0279921 describes a spin transfer oscillator with a seed/SIL/spacer/FGL/capping configuration is disclosed with a composite seed layer made of Ta and a metal layer having a fcc(111) or hcp(001) texture to enhance perpendicular magnetic anisotropy (PMA) in an overlying (A1/A2)x laminated spin injection layer (SIL). Field generation layer (FGL) is made of a high Bs material such FeCo. Alternatively, the STO has a seed/FGL/spacer/SIL/capping configuration. The SIL may include a FeCo layer that is exchanged coupled with the (A1/A2)x laminate (x is 5 to 50) to improve robustness. The FGL may include an (A1/A2)y laminate (y=5 to 30) exchange coupled with the high Bs layer to enable easier oscillations. A1 may be one of Co, CoFe, or CoFeR where R is a metal, and A2 is one of Ni, NiCo, or NiFe. The STO may be formed between a main pole and trailing shield in a write head.

U.S. Publication 2011/0273802 describes a MR sensor is disclosed that has a free layer (FL) with perpendicular magnetic anisotropy (PMA) which eliminates the need for an adjacent hard bias structure to stabilize free layer magnetization and minimizes shield-FL interactions. In a TMR embodiment, a seed layer, free layer, junction layer, reference layer, and pinning layer are sequentially formed on a bottom shield. After patterning, a conformal insulation layer is formed along the sensor sidewall. Thereafter, a top shield is formed on the insulation layer and includes side shields that are separated from the FL by a narrow read gap. The sensor is scalable to widths<50 nm when PMA is greater than the FL self-demag field. Effective bias field is rather insensitive to sensor aspect ratio which makes tall stripe and narrow width sensors a viable approach for high RA TMR configurations. Side shields may be extended below the seed layer plane.

An improved seed layer is still needed that is thin enough to be compatible with spintronic devices, can induce high PMA in overlying Co/Ni multilayer structures, and is compatible with the design and processing requirements of magnetic devices.

### SUMMARY OF THE INVENTION

One objective of the present invention is to provide a seed layer/PMA layer configuration for a magnetic device that has higher Hk and Hc than previously realized and with thermal stability up to 400°C process temperatures.

A second objective of the present invention is to provide a material set for a high PMA structure according to the first objective that is compatible with other layers in the magnetic device and has a seed layer thickness of about 100 Angstroms or less.

In an embodiment these objectives are achieved with a magnetic element according to claim 1, or a MTJ element according to claim 6, in which the seed layer (underlayer) is a composite with a Hf/NiCr, Hf/NiFeCr, NiFeCr/Hf, or NiCr/Hf configuration that induces a strong (111) texture in the overlying Co/Ni multilayer stack within the reference layer. In an alternative embodiment, Ni in the Co/Ni multilayer is replaced by X to give a Co/X multilayer stack within the reference layer where X is one of V, Rh, Ir, Os, Ru, Au, Cr, Mo, Cu, Ti, Re, Si, and Mg. Preferably, the reference layer has a [(Co/Ni)ₙ/CoFeB] or [Co/X)ₙ/CoFeB] configuration where n is from 2 to 30 and the CoFeB (or CoFe) layer serves as a transitional layer between the (111) crystalline structure of the Co/Ni or Co/X multilayer stack and the (100) texture of a MgO tunnel barrier. The transitional layer preferably has PMA and a magnetization aligned in the same direction as the PMA layer. The free layer may be comprised of CoFeB, CoFe, or a combination thereof. Thus, a high MR ratio is achieved together with high PMA in the reference layer to enable greater thermal stability in the magnetic element.

In another embodiment, the MTJ has a top spin valve structure wherein a seed layer, PMA free layer, tunnel barrier, reference layer, and capping layer are sequentially formed on a substrate. The PMA free layer may be a composite with a Co/Ni or Co/X laminate formed on the seed layer and an upper magnetic layer contacting the tunnel barrier. Again, the magnetic layer may be CoFeB and serve as a transitional layer between a (100) MgO tunnel barrier and a Co/Ni multilayer with a (111) texture. The MTJ element according to claim 6, further comprise a Ta insertion layer between the Co/Ni or Co/X multilayer and the transitional layer to prevent premature crystallization of the transitional layer before the tunnel barrier is fabricated.

In yet another embodiment, a dipole layer according to claim 9 is used to provide an offset field to an adjacent free layer. The MTJ has a stack represented by seed layer/reference layer/tunnel barrier/free layer/spacer/dipole layer/capping layer, wherein a lower underlayer of the dipole layer is one of Hf, Hf/NiCr, Hf/ NiFeCr, NiCr/Hf, or NiFeCr/Hf. The spacer may be a non-magnetic Ta layer to getter oxygen from the free layer.

Once all the layers in the MTJ stack are laid down, according to claim 16, a high temperature annealing of about 350°C may be employed to increase the PMA within the Co/Ni laminated portion of the reference layer, free layer, or dipole layer.

Alternatively, the (Co/Ni)ₙ multilayer in the previous embodiments are replaced by a CoFe/Ni, Co/NiFe, Co/NiCo, CoFe/NiFe, or a CoFe/NiCo laminated structure, by pure Co, or may be one of Co/Pt, Co/Pd, Fe/Pt, Fe/Pd, or Fe/V.

In yet another embodiment, the (Co/X) stack described previously is replaced by a disordered alloy that is one of CoV, CoRh, Colr, CoOs, CoRu, CoAu, CoCr, CoMo, CoCu, CoTi, CoRe, CoMg, or CoSi to give a (CoX)ₙ laminated PMA layer.

### BRIEF DESCRIPTION OF THE DRAWINGS

FIG. 1 is a cross-sectional view showing a magnetic element including a composite reference layer with a laminated PMA layer/magnetic transitional layer formed according to an embodiment of the present invention.
FIG. 2 is the magnetic element in FIG. 1 further comprising a Ta insertion layer between the laminated PMA layer and the magnetic transitional layer according to another embodiment of the present invention.
FIG. 3 is cross-sectional view of a magnetic element including a composite free layer formed according to another embodiment of the present invention.
FIG. 4 is a cross-sectional view of a magnetic element including a composite dipole layer formed according to yet another embodiment of the present invention.
FIG. 5 is a cross-sectional view depicting an embodiment wherein a reference layer according to an embodiment is formed in a domain wall motion device.
FIG. 6a is a plot illustrating magnetic properties measured perpendicular to the film plane for Co/Ni multilayers grown on less than optimal seed layers.
FIG. 6b is a plot illustrating magnetic properties measured perpendicular to the film plane for Co/Ni multilayers grown on Hf or NiCr seed layers according to an embodiment of the present invention.
FIGS. 7a, 7b are plots showing magnetic properties measured perpendicular to the film plane and in-plane, respectively, for Co/Ni multilayers grown on Hf/NiCr or NiCr/Hf seed layers according to an embodiment of the present invention.
FIG. 8 shows MH curves measured in a direction perpendicular to the film plane for a MTJ element comprised of a (Co/Ni)₁₀ laminated reference layer formed on a Hf/NiCr seed layer.
FIG. 9 shows MH curves measured in a direction perpendicular to the film plane for a MTJ element comprised of a (Co/Ni)₁₀ laminated dipole layer formed on a NiCr seed layer according to an embodiment of the present invention.

### DETAILED DESCRIPTION OF THE INVENTION

The present invention is a composite structure with a seed layer/PMA layer configuration in a magnetic element wherein the seed layer induces a strong (111) crystalline structure in an overlying (Ni/Co)ₙ, (Co/X)ₙ or (CoX)ₙ multilayer where X is one of V, Rh, Ir, Os, Ru, Au, Cr, Mo, Cu, Ti, Re, Mg, or Si thereby generating high PMA in the laminated stack. Note that "seed layer" may be used interchangeably with the term "underlayer" in the exemplary embodiments, and (Ni/Co)ₙ and (Co/Ni)ₙ, for example, are used interchangeably when referring to a laminated stack. Although only bottom and top spin valve structures are depicted in the drawings, the present invention also encompasses dual spin valves having an enhanced PMA layer that is incorporated in one or more of a reference layer, free layer, dipole layer, or pinned layer in MRAM, spin-torque-MRAM, domain wall motion devices, and in other spintronic devices. Furthermore, the PMA structure may be used as a medium in magnetic sensors or in magnetic data storage applications.

A key feature of the present invention is a (Co/Ni)ₙ or (Co/X)ₙ multilayer structure having PMA where the perpendicular magnetic anisotropy of the aforementioned laminate arises from spin-orbit interactions of the 3d and 4s electrons of Co and Ni (or Co and X) atoms. Such interaction causes the existence of an orbital moment which is anisotropic with respect to the crystal axes which are in (111) alignment, and also leads to an alignment of the spin moment with the orbital moment. PMA character is enhanced by the presence of an appropriate seed layer (underlayer) also having a (111) texture. Ideally, the seed layer has a composition which is compatible with other materials in a magnetic element that contains the (Co/Ni)ₙ or (Co/X)ₙ laminate, is compatible with processing temperatures up to about 400°C, and is thin enough so as not to adversely affect the performance of the magnetic element.

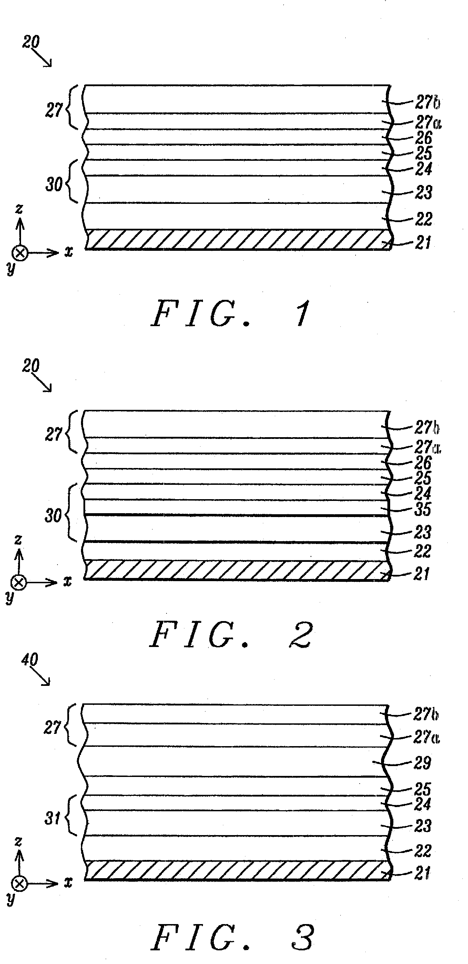

Referring to FIG. 1, a seed layer/PMA multilayer configuration is shown as part of a MTJ **20** with a bottom spin valve structure according to a first embodiment of the present invention. Each of the layers in the MTJ are formed in an (x, y) plane and each have a thickness in a z-axis direction. A substrate **21** is provided that may be a bottom electrode layer, for example, made of Ta or other conductive layers. Substrate **21** may be formed on a substructure (not shown) that includes dielectric and conductive layers as well as transistors and other devices. A key feature is the seed layer **22** formed on substrate **21.** The seed layer **22** has a thickness from 10 to 300 Angstroms, and preferably 10 to 100 Angstroms. The seed layer is Hf. The seed layer 22 is a composite with a Hf/NiCr, Hf/NiFeCr, NiFeCr/Hf, or NiCr/Hf composition wherein the NiCr or NiFeCr layer has a greater thickness than the Hf layer. As a result of the preferred seed layer composition, a (111) texture is induced and fully established in a (Co/Ni)ₙ multilayer or the like grown on a top surface of the seed layer. Top surface in this context is a surface facing away from substrate **21.**

Above the seed layer **22** is a composite reference layer **30** that according to one embodiment has a (Co/Ni)ₙ/CoFeB, a (Co/X)ₙ/CoFeB, or (CoX)ₙ/CoFeB configuration wherein a lower PMA layer **23** has a (Co/Ni)ₙ, (Co/X)ₙ, or (CoX)ₙ composition in which n is from 2 to 30, and preferably between 4 and 10, and CoX is a disordered alloy. PMA layer **23** contacts the seed layer while a magnetic layer **24** made of CoFeB, CoFe, or a combination thereof is formed as an interface between the PMA layer and the tunnel barrier **25.** Each of the plurality of Co layers in the PMA layer has a thickness from 1.5 to 4 Angstroms, and each of the plurality of Ni, X, or CoX layers has a thickness from 4 to 10 Angstroms. In yet another embodiment, PMA layer **23** is pure Co.

In another embodiment, the lower PMA layer **23** is comprised of two metals, a metal and an alloy, or two alloys having an (A1/A2)ₙ configuration where A1 is a first metal or alloy selected from one or more of Co, Ni, and Fe that may be doped with B up to 50 atomic%, A2 is a second metal or alloy selected from one or more of Co, Fe, Ni, Pt, and Pd, n is the number of laminates in the (A1/A2)ₙ stack, and A1 is unequal to A2. It should be understood that the laminated (A1/A2)ₙ stack has intrinsic PMA and the seed layer **22** is employed to enhance the PMA property. Thus, the PMA layer **23** may be comprised of (CoFe/Ni)ₙ, Co/NiFe)ₙ, (Co/NiCo)ₙ, (CoFe/NiFe)ₙ, or (CoFe/NiCo)ₙ laminates, for example. Alternatively, the PMA layer may have a (Co/Pt)ₙ, Co/Pd)ₙ, (Fe/Pt)ₙ, (Fe/Pd)ₙ, or (Fe/V)ₙ composition, or a combination of the aforementioned laminates. In another embodiment, A2 is a second metal or alloy selected from one or more of X, FeX, and CoX. In this case, the PMA layer **23** may be comprised of (CoFe/X)ₙ, Co/FeX)ₙ, (Co/CoX)ₙ, (CoFe/FeX)ₙ, or (CoFe/CoX)ₙ laminates.

In yet another embodiment, the lower PMA layer **23** is comprised of two individual magnetic layers separated by a non-magnetic spacer (C) providing anti-ferromagnetic (RKKY) coupling between the two magnetic layers as in an A1/C/A2 configuration. In this embodiment, the non-magnetic spacer is preferably Ru with a thickness of 3 to 20 angstroms.

The present invention also encompasses an embodiment wherein the lower PMA layer **23** may be an alloy with a L10 structure of the form MT wherein M is Rh, Pd, Pt, Ir, or an alloy thereof, and T is Fe, Co, Ni or alloy thereof. Furthermore, the MT alloy may be doped with B up to 40 atomic%.

Preferably, the magnetic layer **24** has a thickness from about 6 to 14 Angstroms which is sufficiently thin to enable interfacial perpendicular anisotropy to dominate the in-plane shape anisotropy field and thereby generate PMA character therein. According to one embodiment, PMA within magnetic layer **24** is achieved as a result of the interface between a thin CoFeB (or CoFe) layer and a metal oxide layer in tunnel barrier **25** that leads to a significant amount of interfacial perpendicular anisotropy, and the magnetic moments of layers **23, 24** are aligned in the same direction along the z-axis. The magnetic layer serves as a transitional layer between the (111) texture in PMA layer **23** and a (100) texture in tunnel barrier **25** and may also enhance the magnetoresistive (MR) ratio. As the magnetic layer thickness becomes closer to 6 Angstroms, PMA character is maximized, and as layer **24** thickness approaches 14 Angstroms, MR ratio is increased. Therefore, the thickness of the magnetic layer may be adjusted between 6 and 14 Angstroms to tune both PMA magnitude and MR ratio.

There is a tunnel barrier layer **25** preferably made of MgO formed on the composite reference layer **30.** However, other tunnel barrier materials such as AIOx, TiOx, and ZnOx may be employed. A MgO tunnel barrier layer may be fabricated by depositing a first Mg layer on the magnetic layer **24,** then performing a natural oxidation (NOX) process, and finally depositing a second Mg layer on the oxidized first Mg layer. During a subsequent annealing process, the second Mg layer is oxidized to afford a substantially uniform MgO layer. If a low RA (resistance x area) value is desired, the thickness and/or oxidation state of the tunnel barrier **25** may be reduced as appreciated by those skilled in the art.

A free layer **26** is formed on the tunnel barrier layer **25** and may be a composite and comprised of the same composition as in magnetic layer **24.** Preferably, CoFeB, CoFe, or other materials which produce a combination of high MR ratio, good switching property, and low magnetostriction are selected as the free layer.

The uppermost layer in the spin valve stack is a capping layer **27.** In one aspect, the capping layer is a composite with a lower layer **27a** made of Ta and an upper layer **27b** that is Ru which is used to provide oxidation resistance and excellent electrical contact to an overlying top electrode (not shown). A substantial reduction in critical current density (Jc) occurs in STT-MRAM applications when a thin Ru layer is employed as a capping layer due to the strong spin scattering effect of Ru. The Ta layer may be included to offer etch resistance in subsequent processing steps. Optionally, other capping layer configurations may be employed. For example, the capping layer **27** may be a single layer of Ta or Ru, a composite with a Ru/Ta/Ru configuration, or a composite with a lower oxide or nitride layer and an upper Ru layer such as MgO/Ru or AlOx/Ru. An oxide as the lower layer in the capping layer may be advantageously used to promote PMA in a thin free layer **26.**

Referring to FIG. 2, the composite reference layer **30** of an embodiment is modified to include a Ta insertion layer **35** about 0.5 to 3 Angstroms thick, and preferably 1.5 Angstroms thick, sandwiched between the PMA layer and an amorphous CoFeB magnetic layer **24** to prevent crystallization of the CoFeB layer before a MgO tunnel barrier **25** is formed thereon. As a result, crystallization of an amorphous CoFeB layer during a subsequent annealing step is driven by the (100) MgO tunnel barrier and a major portion (not shown) of the magnetic layer crystallizes in a (100) state to maximize the MR ratio in the MTJ. It should be understood that a thin region (not shown) of a CoFeB magnetic layer **24** which adjoins the PMA layer **23** will have a (111) crystal structure or remains amorphous but the thickness of this thin region may be minimized by including the Ta insertion layer **35.**

Referring to FIG. 3, another embodiment is depicted that shows a MTJ **40** wherein the seed layer/PMA layer configuration of the present invention is incorporated in a composite free layer. In other words, the seed layer/PMA layer configuration as defined herein is not limited to a reference (pinned) layer but may be used as any functional or passive layer in a magnetic stack. Preferably, the MTJ in this embodiment has a top spin valve structure in which a seed layer, composite free layer, tunnel barrier, reference layer, and a capping layer are sequentially formed on substrate **21.** The seed layer **22** and PMA layer **23** are retained from the first embodiment but in this case the laminated PMA layer is included in a composite free layer. Reference layer **29** formed on the tunnel barrier is comprised of CoFeB, CoFe, or combinations thereof and may have a well known synthetic anti-parallel (SyAP) configuration (not shown) wherein two ferromagnetic layers such as CoFeB are separated by a coupling layer which is Ru, for example. Tunnel barrier **25** and capping layer **27** are retained from the previous embodiment.

Preferably, the tunnel barrier is MgO to maximize the MR ratio in the MTJ **40.** Furthermore, the composite free layer **31** may have a seed layer **22**/PMA layer **23**/magnetic layer **24** configuration where the magnetic layer serves as a transitional layer between the (100) texture in the tunnel barrier layer and the (111) crystal structure in PMA layer **23** to promote a high MR ratio. Preferably, the magnetic layer **24** is made of CoFeB with a thickness of about 6 to 14 Angstroms so that interfacial perpendicular anisotropy dominates shape anisotropy within the layer to result in PMA with a magnetization direction that is aligned in the same z-axis direction as in PMA layer **23.** The composite free layer **31** may further include a Ta insertion layer (not shown) formed between PMA layer **23** and magnetic layer **24.** Seed layer (underlayer) **22** is one of Hf, Hf/NiCr, Hf/NiFeCr, NiFeCr/Hf, or NiCr/Hf with a 5 to 200 Angstrom thickness to enhance the PMA character in PMA layer **23** thereby increasing thermal stability without compromising other free layer properties.

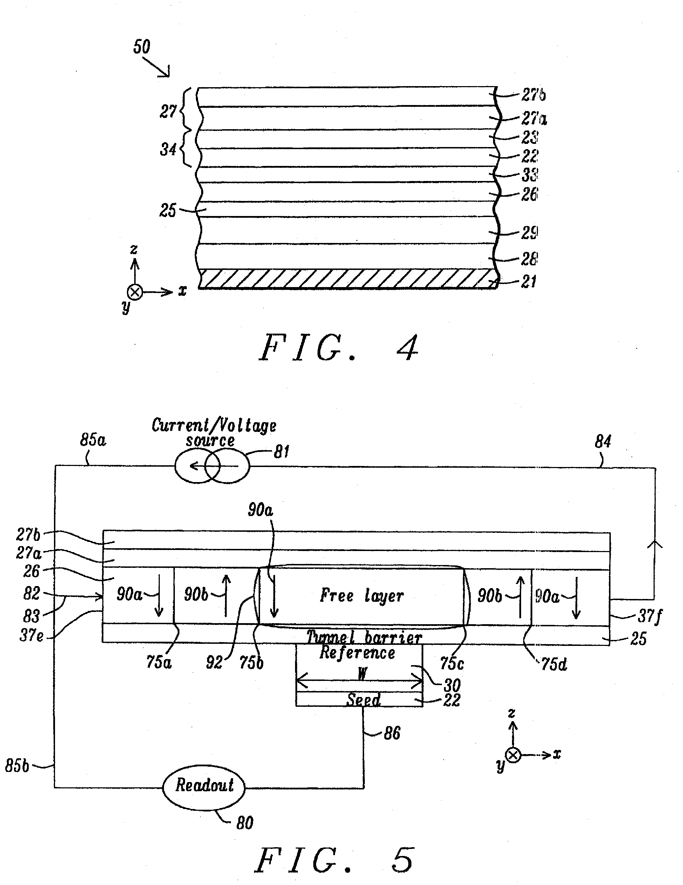

Referring to FIG. 4, yet another embodiment of the present invention is illustrated and depicts a MTJ **50** having a bottom spin valve structure wherein the seed layer/PMA layer of the present invention is employed as a dipole layer to reduce the offset of the minor switching loop of the free layer caused by a dipole field from the reference layer. According to yet another embodiment, a seed layer, reference layer, tunnel barrier, free layer, spacer, dipole layer, and a capping layer are sequentially formed on substrate **21.** The seed layer **28** may be NiCr or NiFeCr. Reference layer **29** and tunnel barrier layer **25** are retained from the previous embodiment. Preferably, the reference layer is thin with a thickness from 5 to 15 Angstroms. Free layer **26** and capping layer **27** were previously described with regard to the previous embodiment. In one aspect, a CoFeB/MgO/CoFeB reference layer/tunnel barrier/ free layer may be employed to provide a high MR ratio.

A key feature is the stack of layers formed between the free layer and capping layer. In particular, a non-magnetic spacer **33** made of Ta, for example, contacts a top surface of free layer **26** and getters oxygen from the free layer. Above the spacer is a composite dipole layer **34** including an underlayer **22** that contacts a top surface of the spacer and a PMA layer **23** that interfaces with capping layer **27.** Layers **22, 23** retain the same features as described with respect to the previous embodiments except the underlayer is preferably 5 to 100 Angstroms thick in this embodiment. In one aspect, free layer **26** may be sufficiently thin (6 to 15 Angstroms) to have significant interfacial perpendicular anisotropy that dominates an in-plane shape anisotropy field such that a magnetization perpendicular to the plane of the free layer is established. Interfacial perpendicular anisotropy is a result of the interface between a bottom surface of free layer **26** and a top surface of tunnel barrier **25** which is preferably MgO. When the free layer has PMA, the magnetization directions of the free layer and PMA layer **23** are preferably aligned in the same direction.

All of the layers in the MTJ elements described herein may be formed in a sputter deposition system such as an Anelva C-7100 thin film sputtering system or the like which typically includes three physical vapor deposition (PVD) chambers each having 5 targets, an oxidation chamber, and a sputter etching chamber. At least one of the PVD chambers is capable of co-sputtering. Typically, the sputter deposition process involves an argon sputter gas with ultra-high vacuum and the targets are made of metal or alloys to be deposited on a substrate. All of the MTJ layers may be formed after a single pump down of the sputter system to enhance throughput.

The present invention also encompasses an annealing step after all layers in the spin valve structure have been deposited. The MTJ elements **20, 40, 50** may be annealed by applying a temperature between 300°C and 400°C for a period of 30 minutes to 5 hours using a conventional oven, or for only a few seconds when a rapid thermal anneal oven is employed. No applied magnetic field is necessary during the annealing step because PMA is established in layer **23** due to the seed layer **22** and because of the Co-Ni (or A1-A2) spin orbital interactions in the laminated PMA layer **23.**

Once all the layers in MTJ elements **20, 40,** or **50** are formed, the spin valve stack is patterned into an oval, circular, or other shapes from a top-down perspective along the z-axis by a well known photoresist patterning and reactive ion etch transfer sequence. Thereafter, an insulation layer (not shown) may be deposited on the substrate **21** followed by a planarization step to make the insulation layer coplanar with the capping layer **27.** Next, a top electrode (not shown) may be formed on the capping layer.

Referring to FIG. 5, an embodiment is depicted wherein the MTJ of previous embodiment is fabricated in a domain wall motion device. In one aspect, composite reference layer **30** is formed in a MTJ stack having a seed layer/reference layer/tunnel barrier/ free layer/capping layer configuration. A key feature is that seed layer **22** and reference layer **30** have a width along an in-plane x-axis direction that is substantially less than the width of the overlying stack of layers. In fact, the stack of layers including tunnel barrier **25,** free layer **26,** and capping layer **27** may be patterned to provide a wire which from a top-down view (not shown) is part of an array of wires that are employed for storage of digital information. Another important feature is that free layer **26** has a plurality of domain walls (**75a -75d**) each extending vertically from a top surface that interfaces with layer **27a** to a bottom surface which interfaces with tunnel barrier layer **25.** There is a magnetic domain bounded by each pair of domain walls within the composite free layer. The number of domain walls is variable but is selected as four in the exemplary embodiment for illustrative purposes. In particular, the magnetic domain **92** aligned in a z-axis direction above reference layer **30** has a switchable magnetization that changes from a (+) z-direction to a (-) z-direction or vice versa when a switching current is applied during a write process. Note that free layer has two ends **37e, 37f** connected to a current/voltage source **81** in a first electrical loop including wiring **85a** to a junction **82** to wire **83** and to end **37e,** and a wire **84** attached to end **37f** to enable a write process. Furthermore, there is a second electrical loop which allows a readout of digital information in the switchable magnetic domain **92** during a read process. Thus, current can be sent from source **81** through wires **85a, 85b** and to readout **80** and then to wire **86** and through reference layer **30,** tunnel barrier **25,** and free layer **26** before exiting end **37f** and returning to the source to complete a circuit. In so doing, the readout device **80** is able to recognize whether the switchable magnetic domain **92** has a magnetization in a (+) z-axis direction **90b** or in a (-) z-axis direction **90a.**

### Example 1

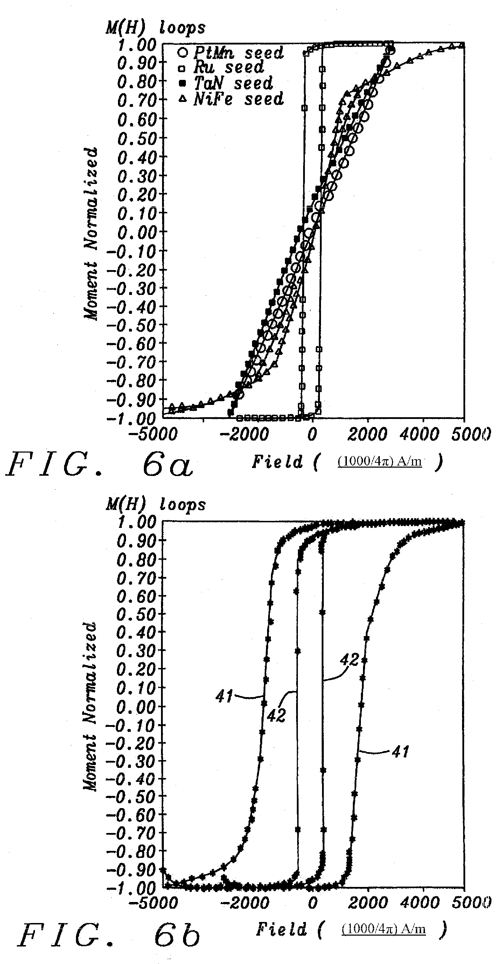

An experiment was performed to demonstrate the advantage of a seed layer in improving PMA in an overlying (Co/Ni)ₙ multilayer stack according to the present invention. A partial and unpatterned spin valve stack comprised of a seed layer, a (Co/Ni)₁₀ laminated layer where each Co layer is 2.5 Angstroms thick and each Ni layer is 6 Angstroms thick, and a Ru cap layer was fabricated in order to obtain PMA values from M-H curves using a vibrating sample magnometer (VSM). All samples were annealed at 350°C for 1 hour. In FIG. 6a, less than ideal seed layers such as TaN, PtMn, NiFe, and Ru were employed. In FIG. 6b, 100 Angstrom thick NiCr and Hf seed layers were formed according to an example outside of the scope of the present invention to provide improved performance including squarer M-H loops and higher coercivity (higher PMA) as depicted in curves **41, 42,** respectively, compared with the films grown on the inadequate seed layers in FIG. 6a. Note that a greater distance between the vertical sections of each pair of curves in FIG. 6b means a higher PMA is achieved. Thus, a NiCr seed layer leads to higher PMA than a Hf seed layer of similar thickness.

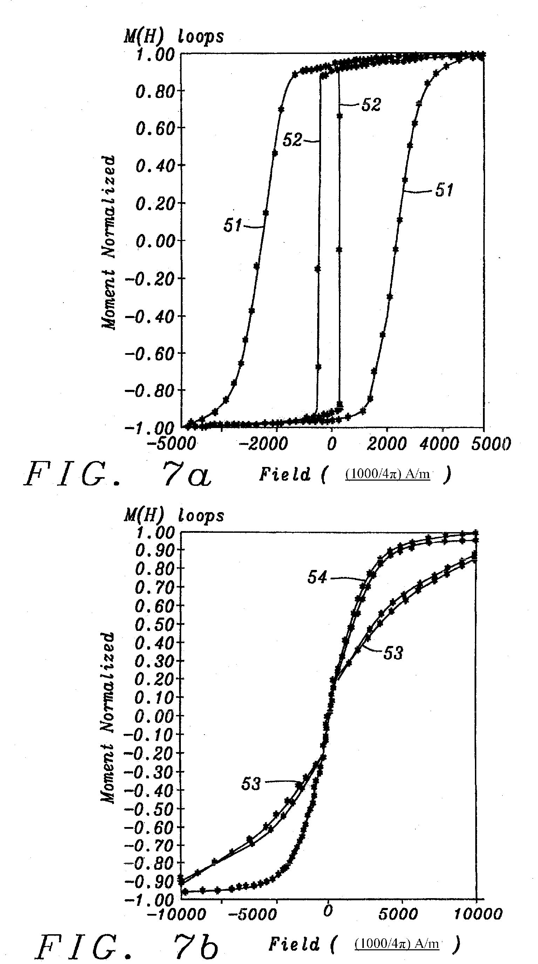

Referring to FIGS. 7a-7b, additional partial spin valve stacks were prepared by sequentially forming a composite seed layer, (Co/Ni)₁₀ laminated layer, and Ru capping layer. Coercivity in an in-plane direction with respect to the film plane is illustrated in FIG. 7b for a Hf20/NiCr100 seed layer configuration (curve **53**) and for a NiCr100/Hf20 seed layer configuration (curve **54**). Magnetization or PMA in a perpendicular-to-plane direction is represented for the Hf/NiCr and NiCr/Hf configurations in curves **51, 52,** respectively in FIG. 7a. The resulting laminated films grown on composite seed layers of the present invention show high coercivity and good squareness. Related measurements on single layer seed films show a high saturation field (perpendicular anisotropy) of about 4000 *(1000/4π) A/m (4000 Oe) for a Hf underlayer and around 10000 (1000/4π) A/m (10000 Oe) for a NiCr underlayer. Note that in a composite seed layer such as Hf/NiCr, the upper layer which contacts the Co/Ni (or A1-A2) laminate has a larger effect in enhancing PMA in the multilayer than the lower layer contacting the substrate. Since a NiCr underlayer generates a higher PMA than a Hf underlayer 10000 (1000/4π) A/m vs. 4000 (1000/4π) A/m (10000 Oe vs. 4000 Oe) as indicated previously, a Hf/NiCr seed layer (curve **51**) leads to a higher PMA than a NiCr/Hf seed layer (curve **52**)

### Example 2

To further demonstrate the benefits of the present invention where the composite seed layer/laminated PMA layer is formed as a reference layer in a MTJ suitable for spin-torque MRAM devices, a MTJ stack was fabricated as represented in the following stack of layers where the number following each layer is the thickness in Angstroms: Si/SiO₂/Ta50/Hf20/NiCr100/ (Co2.5/Ni6)₁₀/ Co₂₀Fe₆₀B₂₀6/MgO/Co₂₀Fe₆₀B₂₀12/Ta20/Ru. In the aforementioned structure, Si/SiO₂ is the substrate, Ta is a bottom electrode, Hf/NiCr is a composite seed layer, (Co/Ni)₁₀ is the laminated PMA portion of the reference layer, CoFeB is the transitional magnetic layer adjoining a MgO tunnel barrier, CoFeB is the free layer, and Ta/Ru is the capping layer. Thus, (Co/Ni)₁₀/Co₂₀Fe₆₀B₂₀ serves as a composite reference layer to provide a high MR ratio wherein the CoFeB portion is thin enough to preserve the PMA property and thick enough to generate a high MR ratio because of cohesive tunneling in the CoFeB/MgO/CoFeB stack of layers. In addition to promoting a high magnetoresistive ratio, the CoFeB free layer is selected for switching purposes. An anneal process comprising a 300°C temperature treatment for 1 hour was used for this experiment.

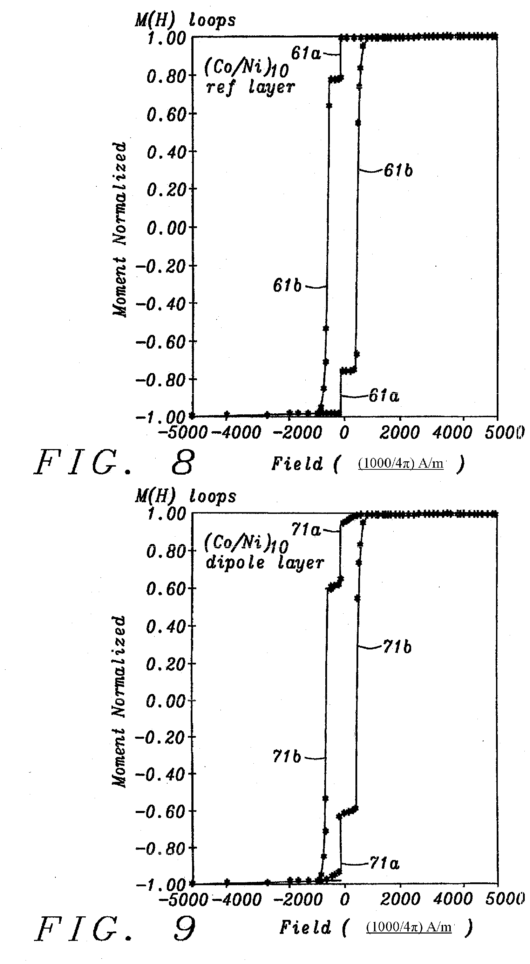

Referring to FIG. 8, a M-H loop measurement is illustrated for the MTJ stack described above and shows significant PMA as a result of the composite reference layer structure, and an additional PMA contribution from the CoFeB free layer. The steps **61a, 61b** in the M-H loop indicate the reference layer and free layer switch independently with the reference layer having a much greater coercivity compared with the free layer as revealed by the greater height for step **61b** related to the reference layer. Therefore, the reference layer may serve as a "pinned layer".

### Example 3

According to yet another embodiment of the present invention, the composite seed layer/laminated PMA layer as described previously may be incorporated as a dipole layer in a MTJ represented in the following stack of layers: Si/SiO₂/Ta50/NiCr100/ Co₂₀Fe₆₀B₂₀3/MgO/Co₂₀Fe₆₀B₂₀ 12/Ta10/NiCr 20/(Co2.5/Ni6)₁₀/Ru. In the aforementioned structure, Si/SiO₂ is the substrate, Ta50 is a 50 Angstrom thick bottom electrode, NiCr100 is a 100 Angstrom thick seed layer, CoFeB/MgO/CoFeB is a reference layer/tunnel barrier/free layer configuration, and Ta10 is non-magnetic spacer with a 10 Angstrom thickness between the free layer and a 20 Angstrom thick NiCr underlayer for the laminated PMA structure which is (Co/Ni)₁₀. Ru is a capping layer.

Referring to FIG. 9, a M-H loop measurement is depicted that shows magnetization in a direction perpendicular to the film plane of the layers in the aforementioned MTJ stack having a dipole layer. In this case, the dipole layer and free layer both have PMA and switch at different fields allowing the two layers to be set in the desired configuration. Step **71b** for the dipole layer is substantially greater than the step **71a** for the free layer. There is no PMA contribution observed for the reference layer which is purposely kept very thin at 3 Angstroms for this experiment. In a functional MTJ, reference layer thickness is generally maintained between 5 and 15 Angstroms and would exhibit substantial PMA. By reducing the thickness of the Ta spacer between the dipole layer and the free layer, the dipole layer is allowed to provide more offset field to the free layer. Moreover, the thickness of the NiCr underlayer adjoining the Co/Ni laminate may be adjusted to amplify or reduce the offset field applied to the free layer.

The MTJ elements described herein feature a seed layer/PMA laminated layer combination which offers enhanced PMA properties together with improved compatibility with high temperature processing, and improved compatibility with the design and fabrication of magnetic devices. As a result, the embodiments of the present invention are suitable for a variety of applications including advanced PMA spin-torque MRAM devices, domain wall motion devices, and in-plane magnetic devices wherein it is beneficial to introduce an out-of-plane magnetic anisotropy component as in in-plane spin torque MRAM devices or in partial PMA spin torque MRAM devices. Improved PMA properties include increased Hc and Hk that enable higher thermal stability up to 400°C processing.

## Claims

1. A magnetic element, comprising:
(a) a seed layer (22) that enhances perpendicular magnetic anisotropy (PMA) in an overlying laminated layer (23); and
(b) the laminated layer (23) having intrinsic PMA and comprising a multilayer stack of two metals, a metal and alloy, or two alloys represented by (A1/A2)ₙ where A1 is a first metal or alloy, A2 is a second metal or alloy selected from X, CoX, and FeX where X is one of V, Rh, Ir, Os, Ru, Au, Cr, Mo, Cu, Ti, Re, Mg, and Si, CoX is a disordered alloy, and n is the number of laminates in the stack, the laminated layer (23) contacts a top surface of the seed layer, or the laminated layer (23) has an (A1/C/A2) configuration where C is a non-magnetic spacer
**characterized in that** the seed layer (22) is one of is one of Hf, Hf/NiCr, Hf/NiFeCr, NiCr/Hf, or NiFeCr/Hf .

2. The magnetic element of claim **1** wherein the seed layer and laminated layer are formed in a magnetic tunnel junction (MTJ) having a seed layer(22)/reference layer(30)/tunnel barrier(25)/free layer(26) configuration, the laminated layer (23) is part of the reference layer (30).

3. The magnetic element of claim **2** wherein the reference layer (30) further comprises a magnetic layer (24) formed between the laminated layer (23) and the tunnel barrier (25) to increase a magnetoresistive (MR) ratio in the MTJ, the magnetic layer interfaces with the tunnel barrier and has PMA with a magnetic moment in a same direction as the PMA in the laminated layer.

4. The magnetic element of claim **1** wherein the seed layer and laminated layer are formed in a MTJ having a reference layer/tunnel barrier/free layer/spacer/seed layer/ dipole layer configuration and the laminated layer is the dipole layer.

5. The magnetic element of claim **1** wherein the seed layer and laminated layer are formed in a MTJ having a seed layer/composite free layer/tunnel barrier/reference layer configuration and the laminated layer is part of the composite free layer.

6. A magnetic tunnel junction (MTJ), comprising:
(a) a seed layer (22) formed on a substrate (21) and that enhances perpendicular magnetic anisotropy (PMA) in an overlying reference layer (30), wherein the reference layer (30) comprises a laminated layer (23);
(b) the laminated layer (23) that is pure Co or having a laminated structure with a plurality of "n" layers that are represented by (Fe/V)ₙ, (Co/X)ₙ or (CoX)ₙ where X is one of V, Rh, Ir, Os, Ru, Au, Cr, Mo, Cu, Ti, Re, Mg, and Si, CoX is a disordered alloy, and the reference layer (30) contacts a top surface of the seed layer (22) and has intrinsic PMA; and
(c) an insertion layer (35) over the laminated layer (23) **characterized in that** the seed layer (22) is one of Hf, Hf/NiCr, Hf/NiFeCr, NiCr/Hf, or NiFeCr/Hf.

7. The MTJ of claim **6** wherein the seed layer has a thickness between about 10 and 300 Angstroms.

8. The MTJ of claim **6** further comprised of a magnetic layer made of CoFeB, CoFe, or combinations thereof that contacts a top surface of the laminated structure.

9. A magnetic tunnel junction (MTJ), comprising:
(a) a reference layer (29) formed on a substrate (21);
(b) a tunnel barrier layer (25) contacting a top surface of the reference layer (29);
(c) a free layer (26) formed on the tunnel barrier layer (25);
(d) a first non-magnetic spacer (33) contacting a top surface of the free layer (26); and
(e) a dipole layer (34) contacting a top surface of the non-magnetic spacer (33), the dipole layer has a lower underlayer (27a), and an upper laminated layer (27b) that has intrinsic perpendicular magnetic anisotropy (PMA) and has a composition represented by (Co/X)ₙ or (CoX)ₙ structure wherein X is one of V, Rh, Ir, Os, Ru, Au, Cr, Mo, Cu, Ti, Re, Mg, and Si, CoX is a disordered alloy, and n is the number of laminates in the stack **characterized in that** the lower underlayer (27a) is one of Hf, Hf/NiCr, Hf/NiFeCr, NiCr/Hf, or NiFeCr/Hf.

10. The MTJ of claim 9 wherein the underlayer has a thickness between about 5 and 100 Angstroms.

11. The MTJ of claim **10** wherein the first non-magnetic spacer is Ta with a thickness from about 0.5 to 2 Angstroms.

12. The MTJ of claim **9** wherein n is from 2 to 30.

13. The MTJ of claim 6 wherein the seed layer and reference layer form a first stack of layers having a first width, the MTJ further comprises a second stack with a tunnel barrier/free layer/capping layer configuration and having a second width substantially greater than the first width, the tunnel barrier contacts a top surface of the first stack and the MTJ is employed as a domain wall motion device.

14. The MTJ of claim **13** wherein n is from 2 to 30.

15. The MTJ of claim **13** wherein the free layer is part of a wire in an array of wires that is used to store digital information.

16. A method of forming a magnetic tunnel junction (MTJ); comprising:
(a) forming a seed layer (22) on a substrate (21), the seed layer (22) enhances perpendicular magnetic anisotropy (PMA) in an overlying laminated layer (23); and
(b) forming the laminated layer (23) having instrinsic PMA that contacts a top surface of the seed layer, the laminated layer has a (Co/X)ₙ or (CoX)ₙ structure wherein X is one of V, Rh, Ir, Os, Ru, Au, Cr, Mo, Cu, Ti, Re, Mg, and Si, CoX is a disordered alloy, and n is the number of laminates in the stack
**characterized in that** the seed layer (22) is one of Hf, Hf/NiCr, Hf/NiFeCr, NiCr/Hf, or NiFeCr/Hf .

17. The method of claim **16** wherein the MTJ has a bottom spin valve configuration in which the seed layer, a composite reference layer, a tunnel barrier layer, and a free layer are sequentially formed on the substrate, and the laminated layer is part of the composite reference layer, the composite reference layer is further comprised of a magnetic layer formed between the laminated layer and the tunnel barrier layer, the magnetic layer has PMA aligned in the same direction as the PMA in the laminated layer.

18. The method of claim **16** wherein the MTJ has a top spin valve configuration in which the seed layer, a composite free layer, a tunnel barrier layer, and a reference layer are sequentially formed on the substrate, and the laminated layer is part of the composite free layer, the composite free layer is further comprised of a magnetic layer formed between the laminated layer and the tunnel barrier layer, the magnetic layer has PMA aligned in the same direction as the PMA in the laminated layer.

19. The method of claim **16** wherein the MTJ has a bottom spin valve configuration in which a reference layer, a tunnel barrier layer, a free layer, a non-magnetic spacer, and a dipole layer are sequentially formed on a substrate, the seed layer and laminated layer are part of the dipole layer.

20. The method of claim **16** wherein n is from 2 to 30.

## Patentansprüche

1. Ein magnetisches Element, umfassend:
(a) eine Keimschicht/Seedlayer(22), die die senkrechte magnetische Anisotropie (PMA) in einer darüberliegenden laminierten Schicht (23) verstärkt; und
(b) die laminierte Schicht (23) mit intrinsischem PMA und umfassend einen mehrschichtigen Stapel von zwei Metallen, einem Metall und einer Legierung oder zwei Legierungen, dargestellt durch (A1/A2)ₙ, wobei A1 ein erstes Metall oder eine erste Legierung ist, A2 ein zweites Metall oder eine zweite Legierung ist, ausgewählt aus X, CoX und FeX, wobei X eines von V, Rh ist, Ir, Os, Ru, Au, Cr, Mo, Cu, Ti, Re, Mg und Si, CoX ist eine ungeordnete Legierung, und n ist die Anzahl der Laminate im Stapel, die laminierte Schicht (23) kontaktiert eine Oberseite der Keimschicht, oder die laminierte Schicht (23) hat eine (A1/C/A2)-Konfiguration, wobei C ein nichtmagnetischer Abstandshalter ist.
**dadurch gekennzeichnet, dass** die Keimschicht(22) eine der folgenden ist: Hf, Hf/NiCr, Hf/NiFeCr, NiCr/Hf oder NiFeCr/Hf.

2. Das Magnetelement nach Anspruch 1, wobei die Keimschicht und die laminierte Schicht in einem magnetischen Tunnelübergang (MTJ) mit einer Konfiguration aus Keimschicht (22)/Referenzschicht (30)/Tunnelbarriere (25)/freier Schicht (26) gebildet sind, die laminierte Schicht (23) ist Teil der Referenzschicht (30).

3. Das Magnetelement nach Anspruch 2, wobei die Referenzschicht (30) ferner eine zwischen der laminierten Schicht (23) und der Tunnelbarriere (25) gebildete Magnetschicht (24) umfasst, um ein magnetoresistives (MR)-Verhältnis im MTJ zu erhöhen, wobei die Magnetschicht mit der Tunnelbarriere verbunden ist und hat ein PMA mit einem magnetischen Moment in einer gleichen Richtung wie das PMA in der laminierten Schicht.

4. Das Magnetelement nach Anspruch 1, wobei die Keimschicht und die laminierte Schicht in einem MTJ mit einer Referenzschicht /Tunnelbarriere / freien Schicht /Abstandshalter /Keimschicht/ Dipolschicht Konfiguration gebildet sind und die laminierte Schicht die Dipolschicht ist.

5. Das Magnetelement nach Anspruch 1, wobei die Keimschicht und die laminierte Schicht in einem MTJ mit einer Konfiguration aus einer Keimschicht / einer zusammengesetzten freien Schicht /einer Tunnelbarriere/Referenzschicht gebildet sind und die laminierte Schicht Teil der zusammengesetzten freien Schicht ist.

6. Magnetischer Tunnelübergang (MTJ), umfassend:
(a) eine auf einem Substrat (21) gebildete Keimschicht (22), die die senkrechte magnetische Anisotropie (PMA) in einer darüberliegenden Referenzschicht (30) verstärkt, wobei die Referenzschicht (30) eine laminierte Schicht (23) umfasst;
(b) die laminierte Schicht (23), die reines Co ist oder eine laminierte Struktur mit einer Vielzahl von "n"-Schichten aufweist, die durch (Fe/V)ₙ, (Co/X)ₙ oder (CoX)ₙ dargestellt werden, wobei X eines von V, Rh, Ir, Os, Ru, Au, Cr, Mo, Cu, Ti, Re, Mg und Si ist, CoX eine ungeordnete Legierung ist, und die Referenzschicht (30) eine Oberseite der Keimschicht(22) berührt und intrinsisches PMA aufweist;
(c) ein Einfügungsschicht (35) über einer laminierten Schicht (23);
**dadurch gekennzeichnet, dass** die Keimschicht(22) eine von Hf, Hf/NiCr, Hf/NiFeCr, NiCr/Hf oder NiFeCr/Hfist.

7. Der MTJ nach Anspruch 6, wobei die Keimschicht eine Dicke zwischen etwa 10 und 300 Angström aufweist.

8. Der MTJ nach Anspruch 6 umfasst ferner eine magnetische Schicht aus CoFeB, CoFe oder Kombinationen davon, die eine Oberseite der laminierten Struktur kontaktiert.

9. Ein magnetischer Tunnelübergang (MTJ), umfassend:
(a) eine Referenzschicht (29), die auf einem Substrat (21) gebildet ist;
(b) eine Tunnelbarriereschicht(25), die eine Oberseite der Referenzschicht (29) berührt;
(c) eine freie Schicht (26), die auf der Tunnelbarriereschicht (25) ausgebildet ist;
(d) einen ersten nichtmagnetischen Abstandshalter (33), der eine Oberseite der freien Schicht (26) berührt; und
(e) eine Dipolschicht (34), die eine Oberseite des nichtmagnetischen Abstandshalters (33) berührt, wobei die Dipolschicht eine untere Unterschicht (27a) aufweist, und eine obere laminierte Schicht (27b), die eine intrinsische senkrechte magnetische Anisotropie (PMA) aufweist und eine Zusammensetzung aufweist, die durch eine (Co/X)ₙ₋ oder (CoX)n-Struktur dargestellt wird, wobei X eine von V, Rh, Ir, Os, Ru, Au, Cr, Mo, Cu, Ti, Re, Mg und Si ist, CoX eine ungeordnete Legierung ist und n die Anzahl der Laminate in dem Stapel ist.
**dadurch gekennzeichnet, dass** die untere Unterschicht (27a) eine von Hf, Hf/NiCr, Hf/NiFeCr, NiCr/Hf oder NiFeCr/Hf ist.

10. Der MTJ nach Anspruch 9, wobei die Unterschicht eine Dicke zwischen etwa 5 und 100 Angström aufweist.

11. Der MTJ nach Anspruch 10, wobei der erste nichtmagnetische Abstandshalter Ta ist mit einer Dicke von etwa 0,5 bis 2 Angström.

12. Der MTJ nach Anspruch 9, wobei n von 2 bis 30 ist.

13. Der MTJ nach Anspruch 6, wobei die Keimschicht und die Referenzschicht einen ersten Stapel von Schichten mit einer ersten Breite bilden, wobei das MTJ ferner einen zweiten Stapel mit einer Tunnelbarriere/freie Schicht/Deckschichtanordnung und einer zweiten Breite, die wesentlich größer als die erste Breite ist, umfasst , die Tunnelbarriere eine Oberseite des ersten Stapels kontaktiert und das MTJ als Domänenwandbewegungsvorrichtung verwendet wird.

14. Der MTJ nach Anspruch 13,wobei n von 2 bis 30 ist.

15. Der MTJ nach Anspruch 13, wobei die freie Schicht Teil eines Drahtes in einer Anordnung von Drähten ist, die zum Speichern digitaler Informationen verwendet wird.

16. Das Verfahren zum Bilden eines magnetischen Tunnelübergangs (MTJ), umfassend:
(a) Bilden einer Keimschicht(22) auf einem Substrat (21), wobei die Keimschicht(22) die senkrechte magnetische Anisotropie (PMA) in einer darüberliegenden laminierten Schicht (23) verstärkt; und
(b) Bilden der laminierten Schicht (23) mit intrinsischem PMA, das eine Oberseite der Keimschicht berührt, wobei die laminierte Schicht eine (Co/X)ₙ₋ oder (CoX)n-Struktur aufweist, wobei X eine von V, Rh, Ir, Os, Ru, Ru, Au, Cr, Mo, Cu, Ti, Re, Mg und Si ist, CoX eine ungeordnete Legierung ist und n die Anzahl der Laminate im Stapel ist.
**dadurch gekennzeichnet, dass** die Keimschicht(22) eine von Hf, Hf/NiCr, Hf/NiFeCr, NiCr/Hf oder NiFeCr/Hf ist.

17. Das Verfahren nach Anspruch 16, wobei das MTJ eine untere Drehventilkonfiguration aufweist, bei der die Keimschicht, eine Verbund-Referenzschicht, eine Tunnelbarriereschicht und eine freie Schicht nacheinander auf dem Substrat gebildet werden, und die laminierte Schicht Teil der Verbund-Referenzschicht ist, die Verbund-Referenzschicht ferner aus einer zwischen der laminierten Schicht und der Tunnelbarriereschicht gebildeten Magnetschicht besteht, die Magnetschicht PMA aufweist, die in der gleichen Richtung ausgerichtet ist wie das PMA in der laminierten Schicht.

18. Das Verfahren nach Anspruch 16, wobei das MTJ eine obere Drehventilkonfiguration aufweist, bei der die Keimschicht, eine zusammengesetzte freie Schicht, eine Tunnelbarriereschicht und eine Referenzschicht nacheinander auf dem Substrat gebildet werden, und die laminierte Schicht Teil der zusammengesetzten freien Schicht ist, die zusammengesetzte freie Schicht ferner aus einer zwischen der laminierten Schicht und der Tunnelbarriereschicht gebildeten magnetischen Schicht besteht, die magnetische Schicht PMA aufweist, die in der gleichen Richtung ausgerichtet ist wie das PMA in der laminierten Schicht.

19. Verfahren nach Anspruch 16, wobei das MTJ eine untere Drehventilkonfiguration aufweist, bei dem eine Referenzschicht, eine Tunnelbarriereschicht, eine freie Schicht, ein nichtmagnetischer Abstandshalter und eine Dipolschicht nacheinander auf einem Substrat gebildet werden, die Keimschicht und die laminierte Schicht Teil der Dipolschicht sind.

20. Verfahren nach Anspruch 16,wobei n von 2 bis 30 ist.

## Revendications

1. Un élément magnétique comprenant:
(a) une couche de germination (22) qui améliore l'anisotropie magnétique perpendiculaire (PMA) dans une couche laminée la recouvrant (23); et
(b) la couche laminée (23) ayant une PMA intrinsèque et comprenant une pile multicouches de deux métaux, un métal et un alliage, ou deux alliages représentés par (A1/A2)ₙ, ou A1 est un premier métal ou alliage, A2 est un second métal ou alliage sélectionné à partir de X, CoX und FeX, dans lequel X est l'un des suivants V, Rh Ir, Os, Ru, Au, Cr, Mo, Cu, Ti, Re, Mg et Si, CoX est un alliage désordonné, et n est le nombre de couches au sein de la pile, la couche laminée (23) faisant contact avec une surface supérieure de la couche de germination, ou la couche laminée (23) ayant une configuration (A1/C/A2) dans laquelle C est un espaceur non magnétique **caractérisé en ce que** la couche de germination (22) est l'une des suivantes Hf, Hf/NiCr, Hf/NiFeCr, NiCr/Hf ou NiFeCr/Hf.

2. L'élément magnétique de la revendication 1, dans lequel la couche de germination et la couche laminée sont formée dans une jonction tunnel magnétique (MTJ) ayant une configuration faite d'une couche de germination(22)/couche de référence (30)/barrière tunnel (25)/couche libre (26, la couche laminée (23) étant partie de la couche de référence (30).

3. L'élément magnétique de la revendication 2, dans lequel la couche de référence (30) comporte en outre une couche magnétique (24) formée entre la couche laminée (23) et la barrière tunnel (25) pour augmenter un taux magnétorésistif (MR) au sein de la MTJ, la couche magnétique interfaçant avec la barrière tunnel et ayant une PMA avec un moment magnétique dans une même direction que la PMA dans la couche laminée.

4. L'élément magnétique de la revendication 1, dans lequel la couche de germination et la couche laminée sont formée dans une MTJ ayant une configuration faite de couche de référence/ barrière tunnel/ couche libre/ espaceur/couche de germination/ couche de dipôle, et la couche laminée est la couche dipôle.

5. L'élément magnétique de la revendication 1, dans lequel la couche de germination et la couche laminée sont formées dans une MTJ ayant une configuration faite d'une couche de germination/ couche libre composite/ barrière tunnel/ couche de référence, et la couche laminée est une partie de la couche libre composite.

6. Une jonction tunnel magnétique (MTJ), comprenant:
(a) une couche de germination (22) formée sur un substrat (21), et qui améliore l'anisotropie magnétique perpendiculaire (PMA) dans une couche de référence sur jacente (30), dans laquelle la couche de référence (30) comporte une couche laminée (23);
(b) la couche laminée (23) qui est du pur Co ou ayant une structure laminée avec une pluralité de "n" couches qui sont représentées par (Fe/V)ₙ, (Co/X)ₙ ou (CoX)ₙ où X est l'un des suivants: V, Rh, Ir, Os, Ru, Au, Cr, Mo, Cu, Ti, Re, Mg et Si, CoX es tun alliage désordonné, et la couche de référence (30) est en contact avec une surface supérieure de la couche de germination (22) et a une PMA intrinsèque; et
(c) une couche d'insertion (35) sur la couche laminée (23)
**caractérisée en ce que** la couche de germination (22) est l'une des suivants: Hf, Hf/NiCr, Hf/NiFeCr, NiCr/Hf ou NiFeCr/Hf.

7. La MTJ de la revendication 6 dans laquelle la couche de germination a une épaisseur comprise entre environ 10 et 300 Angstrôm.

8. La MTJ de la revendication 6 comprenant en outre une couche magnétique faite en CoFeB, CoFe ou de leurs combinaisons faisant contact avec une surface supérieure de la structure laminée.

9. Une jonction tunnel magnétique (MTJ), comprenant:
(a) une couche de référence (29) formée sur un substrat (21);
(b) une couche barrière tunnel (25) faisant contact avec une surface supérieure de la couche de référence (29);
(c) une couche libre (26) formée sur la couche barrière tunnel (25);
(d) un premier espaceur non magnétique (33) faisant contact avec une surface supérieure de la couche libre (26); et
(e) une couche dipole (34), faisant contact avec une surface supérieure de l'espaceur non magnétique (33), la couche dipôle ayat une surface sous-jacente inférieure (27a), et une surface laminée supérieure (27b) qui a une anisotropie magnétique perpendiculaire intrinsèque (PMA) et une composition représentée par une structure (Co/X)ₙ ou (CoX)ₙ, dans laquelle X est l'un des suivants V, Rh, Ir, Os, Ru, Au, Cr, Mo, Cu, Ti, Re, Mg et Si, CoX est un alliage désordonné, et n est le nombre de couches dans la pile
**Caractérisé en ce que** la couche sous-jacente inférieure (27a) est l'un des suivants Hf, Hf/NiCr, Hf/NiFeCr, NiCr/Hf ou NiFeCr/Hf.

10. La MTJ de la revendication 9 dans laquelle la couche sous-jacente a une épaisseur entre 5 et 100 Angstrôm.

11. La MTJ de la revendication 10 dans laquelle le premier espaceur non magnétique est Ta avec une épaisseur d'environ 0,5 à 2 Angstrôm.

12. La MTJ de la revendication 9, dans laquelle n est compris entre 2 et 30.

13. La MTJ de la revendication 6 dans laquelle la couche de germination et la couche de référence forment une première pile de couches ayant une première épaisseur, la MTJ comprenant en outre une seconde pile avec une configuration barrière tunnel/ couche libre/couche de couverture et ayant une seconde épaisseur substantiellement plus grande que la première épaisseur, la barrière tunnel faisant contact avec une surface supérieure de la première pile et la MTJ est employée en tant que dispositif de mouvement mural de domaine.

14. La MTJ de la revendication 13, dans laquelle n est compris entre 2 et 30.

15. La MTJ de la revendication 13 dans laquelle la couche libre es tune partie d'un conducteur au sein d'une zone de conducteurs utilisés pour stocker une information numérique.

16. Un procédé de formation d'une jonction tunnel magnétique (MTJ); comprenant:
(a) la formation d'une couche de germination (22) sur un substrat (21), la couche de germination améliorant l'anisotropie magnétique perpendiculaire (PMA) dans une couche laminée sur jacente (23); et
(b) la formation de la couche laminée (23) ayant une PMA intrinsèque faisant contact avec une surface supérieure de la couche de germination, la couche laminée ayant une structure (Co/X)ₙ ou (CoX)ₙ dans laquelle X est l'un des suivants V, Rh, Ir, Os, Ru, Ru, Au, Cr, Mo, Cu, Ti, Re, Mg et Si, CoX est un alliage désordonné, et n est le nombre de couches dans la pile
**Caractérisé en ce que** la couche de germination (22) est l'un de Hf, Hf/NiCr, Hf/NiFeCr, NiCr/Hf ou NiFeCr/Hf.

17. Le procédé de la revendication 16 dans lequel la MTJ a une configuration de valve de spin inférieure dans laquelle la couche de germination, une couche de référence composite, une couche barrière tunnel, et une couche libre sont séquentiellement formées sur le substrat, et la couche laminée est une partie de la couche de référence composite, la couche de référence composite comprenant en outre une couche magnétique formée entre la couche laminée et la couche barrière tunnel, la couche magnétique ayant une PMA alignée dans la même direction que la PMA de la couche laminée.

18. Le procédé de la revendication 16 dans lequel la MTJ a une configuration de valve de spin supérieure dans laquelle la couche de germination, une couche libre composite, une couche barrière tunnel, et une couche de référence sont séquentiellement formées sur le substrat, et la couche laminée est une partie de la couche libre composite, la couche libre composite comprenant en outre une couche magnétique formée entre la couche laminée et la couche barrière tunnel, la couche magnétique ayant une PMA alignée dans la même direction que la PMA de la couche laminée.

19. Le procédé de la revendication 16 dans lequel la couche MTJ a une configuration de valve de spin inférieure dans laquelle une couche de référence, une couche barrière tunnel, une couche libre, un espaceur non magnétique, et une couche dipôle sont séquentiellement formée sur un substrat, la couche de germination et la couche laminée étant partie de la couche dipôle.

20. Le procédé de la revendication 16 dans lequel n est compris entre 2 et 30.
